# EUROPEAN PATENT SPECIFICATION

(11) **EP 2 752 871 B1**
(45) Date of publication and mention of the grant of the patent: **16.09.2015**
(21) Application number: 13150530.7
(22) Date of filing: 08.01.2013
(51) Int. Cl.: H01L 21/683

(54) **Method of application of a carrier to a device wafer**
Verfahren der Anwendung eines Trägers auf einen Vorrichtungswafer
Procédé d'application d'un support sur une tranche de dispositif

(43) Date of publication of application: 09.07.2014
(73) Proprietor: ams AG, 8141 Unterpremstätten (AT)
(72) Inventor: Siegert, Jörg, 8020 Graz (AT); Schrems, Martin, 8063 Eggersdorf (AT); Schrank, Franz, 8052 Graz (AT); Kraft, Jochen, 8600 Oberaich (AT)
(74) Representative: Epping - Hermann - Fischer

(56) References cited:
- WO-A2-2009/094558
- US-A1- 2012 193 014

## Description

Semiconductor wafers having a thickness of less than 200 µm are particularly suitable for the formation of chip stacks in three-dimensional integration. During manufacture the wafer is fastened to a handling wafer to allow the wafer to be thinned and submitted to further process steps without risk of breaking. The material that fastens the wafer to the handling wafer must be sufficiently inert to chemicals used in the process and must withstand elevated temperatures of typically up to 400°C as well as low-pressure conditions occurring in deposition and cleaning steps. Furthermore, the subsequent removal of the handling wafer must not adversely affect the integrated devices of the semiconductor wafer.

US 2008/0014715 A1 discloses a method for the processing of wafers. A device wafer is bonded to a carrier wafer, which supports the device wafer only at its edge, where a bonding substance is applied. After further process steps have been performed, the bonding substance is heated, so that the device wafer can be detached from the carrier wafer.

US 2009/0218560 A1 discloses a method of production in which a device wafer is bonded to a carrier wafer only at the perimeter. A fill layer surrounded by a material forming an edge bond is arranged between the device wafer and the carrier wafer. The edge bond can be softened, dissolved or mechanically disrupted to allow the wafers to be separated at or near room temperature.

US 2012/0193014 A1 discloses a method of wafer bonding. An adhesive is applied in a center zone of the wafer, which is then spun at a high speed to evenly distribute the adhesive. A reduction of edge chipping is to be achieved by applying extra adhesive at the periphery of the wafer.

It is an object of this invention to disclose a method of application of a carrier to a device wafer, which provides a good support and facilitates a subsequent removal.

This object is achieved with the method according to claim 1. Variants derive from the dependent claims.

The method comprises the steps of providing a device wafer having a main surface including an edge region and providing a carrier having a further main surface including an annular surface region corresponding to the edge region of the device wafer, applying an adhesive in the edge region and/or in the annular surface region, but not on the remaining areas of the main surface and the further main surface, and fastening the device wafer to the carrier by the adhesive. Thereby the main surface is brought into contact with the further main surface inside and outside the edge region, while only the edge region is bonded to the further main surface by the adhesive. Further process steps can be performed while the device wafer is supported by the carrier. In particular, further process steps may include the production of through-wafer vias. The device wafer is afterwards removed from the carrier.

In a variant of the method the device wafer is removed from the carrier by partially removing the adhesive and then mechanically debonding the device wafer from the carrier. According to the invention, a recess is formed in the annular surface region of the carrier, and the adhesive is applied in the recess before the device wafer is fastened to the carrier.

In a further variant of the method, a further recess is formed in the vicinity of the annular surface region of the carrier. The further recess may be provided to accomodate surplus adhesive.

In a further variant of the method, a step is formed in the edge region of the device wafer, and the adhesive is applied adjacent to the step. The main surface may especially be provided on a dielectric layer, which forms the step.

In a further variant of the method, the main surface is provided with a roughness preventing the main surface from sticking to the further main surface in an area where no adhesive is applied.

The following is a detailed description of examples of the semiconductor device and of the appertaining method of production.
- Figure 1: is a cross section of an arrangement of a device wafer and a carrier during the process of being separated from one another.
- Figure 2: is a cross section of an arrangement of a device wafer and a carrier before being fastened to one another.
- Figure 3: is a cross section according to Figure 2 after the device wafer and the carrier have been fastened to one another.
- Figure 4: is a cross section according to Figure 3 after further process steps.
- Figure 5: is a cross section according to Figure 2 example not forming part of the present invention.
- Figure 6: is a cross section according to Figure 5 after the device wafer and the carrier have been fastened to one another.
- Figure 7: is a cross section according to Figure 6 for a further embodiment.
- Figure 8: is a cross section of a further embodiment of the carrier.

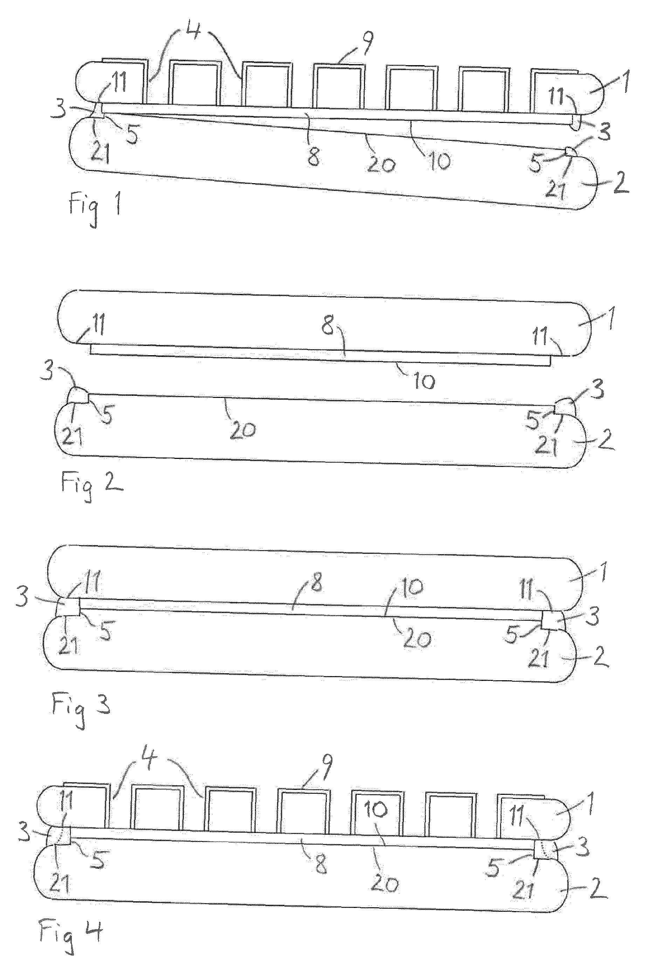

Figure 1 is a cross section of an arrangement of a device wafer 1 and a carrier 2 during a process step in which the device wafer 1 is separated from the carrier 2. A main surface 10 of the device wafer 1 faces a further main surface 20 of the carrier 2. In the embodiment shown in Figure 1, the main surface 10 is a surface of a dielectric layer 8, which may comprise a wiring of an integrated circuit of the device wafer 1, for example. The dielectric layer 8 may serve as an intermetal dielectric between metal layers forming the wiring. The integrated circuit may especially be a CMOS circuit, for example. The main surface 10 may instead be formed by a layer of another material, like a passivation layer, or by the surface of a semiconductor body of the device wafer 1. The dielectric layer 8 is shown in the described embodiments to indicate that the main surface 10 may be that side of the device wafer 1 where the circuit components are integrated. The device wafer 1 may be provided with through-wafer vias 4 and a wiring layer 9 on the surface opposite the carrier 2, for example.

An adhesive 3, which was used to fasten the device wafer 1 to the carrier, is located in an edge region 11 of the main surface 10 of the device wafer 1 and in a corresponding annular surface region 21 of the carrier 2. A recess 5 covering the annular surface region 21 is provided at the edge of the further main surface 21 for the application of the adhesive 3.

In the embodiments shown in the Figures, the device wafer 1 and the carrier 2 have the same dimensions, but the carrier 2 need not have the same dimension as the device wafer 1. The area of the further main surface 20 which is fastened to the edge region 11 of the device wafer 1 by means of the adhesive 3 is therefore designated as an annular surface region 21, which is not necessarily on the edge of the carrier 2.

In the state of the method represented in Figure 1, the adhesive 3 has already partially be removed, so that the device wafer 1 can mechanically be detached from the carrier 2 by applying a moderate force. The residues of the adhesive 3 may then be disposed of when the wafer is diced.

The method is further described in conjunction with Figures 2 to 4. Figure 2 is a cross section of an arrangement of a device wafer 1 and a carrier 2 before they are fastened to one another. The elements that correspond to similar elements shown in Figure 1 are designated with the same reference numerals. At its perimeter, the carrier 2 is provided with a recess 5, which may be a few microns deep, typically 5 µm, for instance, and a few millimetres wide, typically 3 mm, for instance. An adhesive 3 is dispensed exclusively along the perimeter of the carrier 2. The recess 5 enables the application of a sufficiently thick layer of the adhesive 3, which preferably only slightly exceeds the level of the further main surface 21.

Figure 3 is a cross section according to Figure 2 after the device wafer 1 and the carrier 2 have been fastened to one another. Any surplus adhesive 3 is pushed outwards when the main surface 10 is approached to the further main surface 20. The bond is effected by the adhesive 3 and is confined to the margin of the device wafer 1. Air that may have been trapped in the unbonded central region between the device wafer 1 and the carrier 2 may pose a risk of an uncontrolled delamination of the device wafer 1 from the carrier 2 during further process steps that are performed at a high temperature. This can be avoided if the bonding takes place under low-pressure conditions and/or at an elevated temperature, which typically prevails in wafer bonding chambers. In this way the main surface 10 and the further main surface 20 are brought into contact with one another, while the bond is confined to the periphery.

Before the device wafer 1 is fastened to the carrier, the main surface 10 may be provided with a determined roughness in order to prevent the main surface 10 from sticking to the further main surface 20 in an area outside the edge region 11, hence in an area where no adhesive 3 is applied and no bonding is desired. The roughness may facilitate the debonding step. On the other hand, the main surface 10 is preferably sufficiently smooth to secure an effective support of the device wafer 1 by the carrier 2, the support being essentially homogeneous over the entire surface.

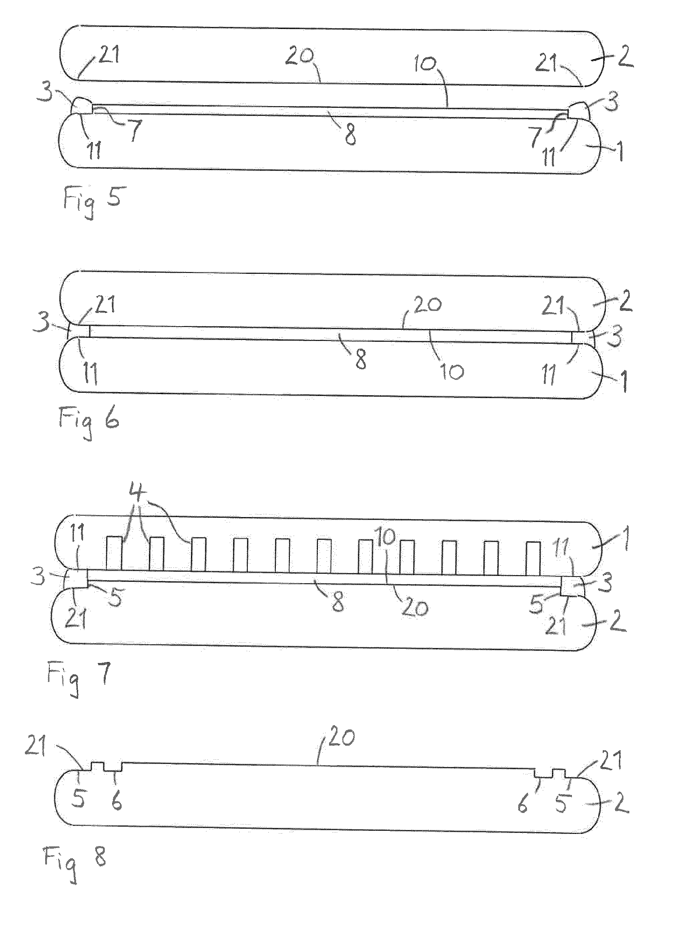

Figure 4 is a cross section according to Figure 3 after further process steps. The elements that correspond to similar elements shown in Figure 3 are designated with the same reference numerals. The device wafer 1 has been thinned from the rear side opposite the carrier 2 and has been provided with through-wafer vias 4 and a wiring layer 9, which may be a redistribution layer, for example. The thinned device wafer 1 is mechanically stabilized by the carrier 2 during the further process steps. The device wafer 1 can then be removed from the carrier 2. To this end the adhesive 3 may be completely removed by a solvent. The adhesive 3 may instead be only partially removed by the solvent. The boundary of the remaining portion of the adhesive 3 is indicated in Figure 4 by the dotted line traversing the area representing the adhesive 3. The rest of the adhesive 3 is sufficient to allow a controlled mechanical detachment of the device wafer 1 from the carrier 2 by an application of a comparatively low force. The method step of the mechanical detachment is illustrated in Figure 1. Figure 5 is a cross section according to Figure 2 not forming part of the present invention. The elements that correspond to similar elements shown in Figure 2 are designated with the same reference numerals. In the embodiment according to Figure 5 the adhesive 3 is applied to the device wafer 1. If the edge region 11 of the main surface 10 is left free from the dielectric layer 8, a step 7 is formed at the edge of the dielectric layer 8. The step 7 can be used to confine the adhesive 3 to the edge region 11, and the step 7 has a function similar to the function of the recess 5 in the preceding embodiment. The adhesive 3 preferably only slightly exceeds the level of the main surface 10.

Figure 6 is a cross section according to Figure 5 after the device wafer 1 and the carrier 2 have been fastened to one another. Except for the absence of the recess 5 the arrangement shown in Figure 6 equals the arrangement according to Figure 3. Any surplus adhesive 3 is pushed outwards when the main surface 10 is approached to the further main surface 20. The bond is effected by the adhesive 3 and is confined to the margin of the device wafer 1. The main surface 10 and the further main surface 20 are in contact with one another, while the bond is confined to the periphery.

Figure 7 is a cross section according to Figure 6 for a further embodiment of the arrangement of the device wafer 1 and the carrier 2. In the example shown in Figure 7 the device wafer 1 comprises a high surface topography, which may be due to through-wafer vias 4 that are in this case produced before bonding the device wafer 1 to the carrier. The described method does not leave any residues in the region of the high surface topography after debonding, because no adhesive is applied in the central area of the device wafer 1. Cleaning the device wafer 1 is thus not necessary or at least essentially facilitated.

Figure 8 is a cross section of a further embodiment of the carrier 2, which is here provided with a recess 5 and a further recess 6 in the vicinity of the annular surface region 21 at the edge of the carrier 2. The further recess 6 is not filled with the adhesive 3, but it is provided for the accomodation of surplus adhesive 3, which is thus prevented from being squeezed towards the central area of the carrier 2 when the device wafer 1 is fastened.

The described method enables a temporary bond between a device wafer 1 and a carrier 2 providing an essentially homogeneous support without use of an intermediate layer. Because the bond is effected by an adhesive 3 that is confined to the periphery, the device wafer 1 can easily be detached from the carrier 2, and residues of the adhesive 3 are only left at the margin of the device wafer 1. The method allows various adhesives 3 to be selected, including high-temperature stable adhesives 3, so that process steps can be performed at an elevated temperature while the device wafer 1 is supported by the carrier 2. The carrier 2 supports the device wafer 1 also in the centre with no need of an intermediate layer.

### List of reference numerals

- 1: device wafer
- 2: carrier
- 3: adhesive
- 4: through-wafer via
- 5: recess
- 6: further recess
- 7: step
- 8: dielectric layer
- 9: wiring layer
- 10: main surface
- 11: edge region
- 20: further main surface
- 21: annular surface region

## Claims

1. A method of application of a carrier, comprising:
- providing a device wafer (1) having a main surface (10) including an edge region (11),
- providing a carrier (2) having a further main surface (20) including an annular surface region (21) corresponding to the edge region (11),
- applying an adhesive (3) to the main surface (10), to the further main surface (20) or both to the main surface (10) and to the further main surface (20),
- fastening the device wafer (1) to the carrier (2), the adhesive (3) bonding the edge region (11) to the annular surface region (21), and
- bringing the main surface (10) into contact with the further main surface (20) inside the edge region (11) and outside the edge region (11),
**characterized in that**
- a recess (5) is formed in the annular surface region (21),
- the adhesive (3) is applied in the recess (5) and is confined to the edge region (11) and to the annular surface region (21), respectively, and
- the main surface (10) is brought into contact with the further main surface (20) such that the adhesive (3) is only present between the edge region (11) of the main surface (10) and the annular surface region (21) of the further main surface (20).

2. The method of claim 1, wherein
further process steps include the formation of through-wafer vias (4) in the device wafer (1).

3. The method of claim 1 or 2, wherein
the device wafer (1) is removed from the carrier (2) by partially removing the adhesive (3) and then mechanically debonding the device wafer (1) from the carrier (2).

4. The method of one of claims 1 to 3, further comprising:
forming a further recess (6) in the vicinity of the annular surface region (21).

5. The method of one of claims 1 to 4, further comprising:
forming a step (7) in the edge region (11), and
applying the adhesive (3) adjacent to the step (7).

6. The method of claim 5, further comprising:
providing the main surface (10) on a dielectric layer (8), which forms the step (7).

7. The method of one of claims 1 to 6, further comprising:
providing the main surface (10) with a roughness preventing the main surface (10) from sticking to the further main surface (20) in an area where no adhesive (3) is applied.

## Patentansprüche

1. Verfahren zum Aufbringen eines Trägers, Folgendes umfassend:
- Bereitstellen eines Bauteilwafers (1), der eine Hauptfläche (10) einschließlich eines Randbereichs (11) hat,
- Bereitstellen eines Trägers (2), der eine weitere Hauptfläche (20) einschließlich eines dem Randbereich (11) entsprechenden ringförmigen Flächenbereichs (21) hat,
- Auftragen eines Klebstoffs (3) auf die Hauptfläche (10), auf die weitere Hauptfläche (20), oder sowohl auf die Hauptfläche (10) als auch auf die weitere Hauptfläche (20),
- Befestigen des Bauteilwafers (1) am Träger (2), wobei der Klebstoff (3) den Randbereich (11) an den ringförmigen Flächenbereich (21) bindet, und
- Bewirken, dass die Hauptfläche (10) innerhalb des Randbereichs (11) und außerhalb des Randbereichs (11) in Kontakt mit der weiteren Hauptfläche (20) gebracht wird,
**dadurch gekennzeichnet, dass**
- eine Ausnehmung (5) im ringförmigen Flächenbereich (21) gebildet wird,
- der Klebstoff (3) in der Ausnehmung (5) aufgetragen und auf den Randbereich (11) bzw. den ringförmigen Flächenbereich (21) beschränkt wird, und
- die Hauptfläche (10) mit der weiteren Hauptfläche (20) so in Kontakt gebracht wird, dass der Klebstoff (3) nur zwischen dem Randbereich (11) der Hauptfläche (10) und dem ringförmigen Flächenbereich (21) der weiteren Hauptfläche (20) vorhanden ist.

2. Verfahren nach Anspruch 1, wobei
weitere Prozessschritte die Ausbildung von Waferdurchkontaktierungen (4) im Bauteilwafer (1) umfassen.

3. Verfahren nach Anspruch 1 oder 2, wobei der Bauteilwafer (1) vom Träger (2) entfernt wird, indem der Klebstoff (3) teilweise entfernt und dann der Bauteilwafer (1) mechanisch vom Träger (2) abgelöst wird.

4. Verfahren nach einem der Ansprüche 1 bis 3, darüber hinaus umfassend: Ausbilden einer weiteren Ausnehmung (6) im Nahbereich des ringförmigen Flächenbereichs (21).

5. Verfahren nach einem der Ansprüche 1 bis 4, darüber hinaus umfassend: Ausbilden einer Stufe (7) im Randbereich (11) und Auftragen des Klebstoffs (3) angrenzend an die Stufe (7).

6. Verfahren nach Anspruch 5, darüber hinaus umfassend:
Bereitstellen der Hauptfläche (10) auf einer dielektrischen Schicht (8), welche die Stufe (7) bildet.

7. Verfahren nach einem der Ansprüche 1 bis 6, darüber hinaus umfassend: Versehen der Hauptfläche (10) mit einer Rauigkeit, die verhindert, dass die Hauptfläche (10) an der weiteren Hauptfläche (20) in einem Bereich, in dem kein Klebstoff (3) aufgetragen ist, anhaftet.

## Revendications

1. Procédé d'application d'un support, comprenant:
- la mise à disposition d'une tranche de dispositif (1) présentant une surface principale (10) incluant une région de bord (11),
- la mise à disposition d'un support (2) présentant une surface principale supplémentaire (20) incluant une région de surface annulaire (21) correspondant à la région de bord (11),
- l'application d'un adhésif (3) sur la surface principale (10), sur la surface principale supplémentaire (20) ou à la fois sur la surface principale (10) et sur la surface principale supplémentaire (20),
- la fixation de la tranche de dispositif (1) au support (2), l'adhésif (3) liant la région de bord (11) à la région de surface annulaire (21), et
- la mise en contact de la surface principale (10) avec la surface principale supplémentaire (20) à l'intérieur de la région de bord (11) et à l'extérieur de la région de bord (11),
**caractérisé en ce que**
- une cavité (5) est formée dans la région de surface annulaire (21),
- l'adhésif (3) est appliqué dans la cavité (5) et est confiné à la région de bord (11) et à la région de surface annulaire (21), respectivement, et
- la surface principale (10) est mise en contact avec la surface principale supplémentaire (20) de telle sorte que l'adhésif (3) soit seulement présent entre la région de bord (11) de la surface principale (10) et la région de surface annulaire (21) de la surface principale supplémentaire (20).

2. Le procédé de la revendication 1, dans lequel des étapes de procédé supplémentaires incluent la formation de trous traverse-tranche (4) dans la tranche de dispositif (1).

3. Le procédé de la revendication 1 ou 2, dans lequel on enlève la tranche de dispositif (1) du support (2) en enlevant partiellement l'adhésif (3) puis en déliant mécaniquement la tranche de dispositif (1) du support (2).

4. Le procédé de l'une des revendications 1 à 3, comprenant en outre: la formation d'une cavité supplémentaire (6) à proximité de la région de surface annulaire (21).

5. Le procédé de l'une des revendications 1 à 4, comprenant en outre: la formation d'un échelon (7) dans la région de bord (11), et l'application de l'adhésif (3) de façon adjacente à l'échelon (7).

6. Le procédé de la revendication 5, comprenant en outre: le fait de disposer la surface principale (10) sur une couche diélectrique (8), laquelle forme l'échelon (7).

7. Le procédé de l'une des revendications 1 à 6, comprenant en outre: le fait de doter la surface principale (10) d'une rugosité empêchant que la surface principale (10) ne colle à la surface principale supplémentaire (20) dans une zone où aucun adhésif (3) n'est appliqué.
